(19) Europäisches Patentamt / European Patent Office / Office européen des brevets

(11) **EP 3 965 293 A2**

(12) **EUROPEAN PATENT APPLICATION**

(43) Date de publication:
**09.03.2022 Bulletin 2022/10**

(21) Numéro de dépôt: **21199059.3**

(22) Date de dépôt: **08.12.2015**

(51) Classification Internationale des Brevets (IPC):
*H03H 9/02* (2006.01)  *H03H 9/145* (2006.01)
*H03H 9/64* (2006.01)  *B60W 50/00* (2006.01)
*G01S 13/75* (2006.01)

(52) Classification Coopérative des Brevets (CPC):
**H03H 9/642; H03H 9/02637; H03H 9/14529;
H03H 9/14544; H03H 9/643;** H03H 9/14541

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.12.2014 FR 1462182**

(62) Numéro(s) de document de la (des) demande(s)
initiale(s) en application de l'article 76 CBE:
**20196942.5 / 3 793 088**
**15198414.3 / 3 032 742**

(71) Demandeur: **SASU FREC'N'SYS
25000 Besancon (FR)**

(72) Inventeurs:
• **Daniau, William
25660 Montfaucon (FR)**

• **Laroche, Thierry
25000 Besançon (FR)**
• **Ballandras, Sylvain
25000 Besancon (FR)**

(74) Mandataire: **Grünecker Patent- und
Rechtsanwälte
PartG mbB
Leopoldstraße 4
80802 München (DE)**

Remarques:
This application was filed on 27-09-2021 as a
divisional application to the application mentioned
under INID code 62.

(54) **DISPOSITIF DE CAPTEUR A ONDES ELASTIQUES DE SURFACE A REPONSE ELECTRIQUE STABLE**

(57) Dispositif de capteur à ondes élastiques de surface interrogeable à distance comprenant un transducteur à peignes inter-digités et deux miroirs de Bragg disposés d'un côté et de l'autre du transducteur, l'ensemble formant un résonateur simple-port, le transducteur présentant une fréquence de synchronisme f1 et une bande interdite entre les fréquences f2 et f3 et les miroirs de Bragg présentant une bande interdite entre les fréquences f4 et f5, la fréquence f1 étant comprise dans la bande interdite f4-f5 des miroirs de Bragg, la bande interdite f2-f3 du transducteur étant située hors de la bande interdite f4-f5 des miroirs de Bragg.

Miroir M1
2d/

Gap g1

Transducteur 3d/

Gap g2

Miroir M2
2d/

Fig. 6

EP 3 965 293 A2

$$3 \times \lambda = 8 \times p$$

Fig.17

**Description**

Le domaine de l'invention est celui des transpondeurs à ondes élastiques de surface et des dispositifs associés. Les dispositifs à ondes élastiques de surface encore appelés dispositifs *"SAW"*, acronyme anglais de *"Surface Acoustic Wave"* sont utilisés pour réaliser des systèmes d'interrogation à distance, en particulier à une distance supérieure à celle permise par les étiquettes RFID.

Cette technologie est plus particulièrement mise en œuvre pour des dispositifs d'interrogation de capteurs passifs à ondes élastiques de surface. Ces capteurs peuvent être utilisés comme capteurs de température de pression. Les capteurs à ondes élastiques de surface comprennent généralement au moins un résonateur comportant une micro structure déposée à la surface d'un substrat piézoélectrique. Comme illustré dans FR 2 906 630, un capteur peut comprendre deux transducteurs à peignes d'électrodes inter-digitées placés entre des réseaux réflecteurs. Les réseaux réflecteurs se comportent comme des miroirs, notamment des miroirs de Bragg.

Les Demanderesses ont découvert que les propriétés du transducteur peuvent évoluer en fonction de conditions paramétriques auxquelles le résonateur est soumis en ce sens que les transducteurs à deux doigts par longueur d'onde, fonctionnant auxdites conditions de Bragg peuvent voir leurs propriétés de directivité modifiées lors d'une évolution de paramètre telle qu'une variation de température ou de contraintes mécaniques. Ceci entraîne alors une distorsion de la réponse électrique et peut engendrer des difficultés d'interprétation des mesures voire des erreurs dues à des sauts de fréquence lors de la phase de détection.

Un but est de disposer d'un capteur à réponse aisée à interpréter sur une large gamme de paramètres, tels que température, contraintes mécaniques, etc.

Un but est d'améliorer la stabilité de la directivité.

Un dispositif de capteur à ondes élastiques de surface interrogeable à distance comprend un transducteur à peigne inter-digité et deux miroirs de Bragg disposés d'un côté et de l'autre du transducteur, l'ensemble formant un résonateur simple-port, le transducteur présentant une fréquence de synchronisme f1 et une bande interdite entre les fréquences f2 et f3 et les miroirs de Bragg présentant une bande interdite entre les fréquences f4 et f5, la fréquence f1 étant comprise dans la bande interdite f4-f5 des miroirs de Bragg, la bande interdite f2-f3 du transducteur étant située hors de la bande interdite f4-f5 des miroirs de Bragg, de façon que le capteur offre une réponse spectrale monomode.

Dans un mode de réalisation, le transducteur comprend des doigts parallèles de période comprise entre 1/3 et 1/2 de la longueur d'onde $\lambda = V1/f1$, une période étant la somme d'une largeur digitale et d'une largeur interdigitale.

Dans un mode de réalisation, le transducteur comprend sept doigts de période sensiblement égale à 3 fois la longueur d'onde $\lambda = V1/f1$, préférentiellement en configuration +V/-V/+V/+V/-V/+V/-V.

Dans un mode de réalisation, le transducteur comprend cinq doigts de période sensiblement égale à 2 fois la longueur d'onde $\lambda = V1/f1$, préférentiellement en configuration +V/+V/-V/-V/+V ou +V/-V/-V/+V/+V/-V.

Dans un mode de réalisation, le transducteur comprend huit doigts de période sensiblement égale à 3 fois la longueur d'onde $\lambda = V1/f1$, préférentiellement en configuration 0/-V/+V/-V/0/+V/-V/+V, 0 étant un potentiel flottant.

Dans un mode de réalisation, les miroirs de Bragg présentent au sein de la bande interdite f4-f5 un maximum de réflexion à une fréquence f6, et le transducteur présentant un maximum d'excitation à une fréquence f7, f6 = f7 à 10% de la largeur $\delta f$ de la bande interdite des miroirs de Bragg près, avec $\delta f = (f4-f5)$.

Dans un mode de réalisation, le résonateur comprend un substrat piézoélectrique comprenant au moins un matériau choisi parmi: langasite, quartz, LiTaO$_3$, LiNbO$_3$, GaPO$_4$, LiBa$_4$O$_7$, KNbO$_3$, un film mince comprenant une couche d'AIN, d'AlScN ou de ZnO sur un substrat à base de Si, saphir, grenat (YAG, YIG), carbure de silicium, diamant synthétique, verre et ses composés dérivés, ou quartz.

Dans un mode de réalisation, le résonateur comprend des électrodes déposées à la surface d'un substrat piézoélectrique, les électrodes comprenant au moins un matériau choisi parmi: Al, Ti, Pt, Ta, Au, W, Ir, Ni, Cr, Mo, Zr, Pd, Ag, Cu, alliage comprenant plus de 90% d'Al et au moins un parmi : Cu, Si et Ti.

Dans un mode de réalisation, chaque miroir de Bragg comprend un nombre de couches compris entre 50 et 1000.

Dans un mode de réalisation, chaque miroir de Bragg comprend un nombre de couches proportionnel au coefficient de réflexion de l'onde élastique sur une couche unique. Dans un mode de réalisation, les miroirs de Bragg sont disposés symétriquement par rapport au transducteur.

Dans un mode de réalisation, les miroirs de Bragg sont disposés à des distances d$_1$ et d$_2$ du transducteur comprises entre 10 et 1000 fois la longueur d'onde V1/f1 de façon que la propagation de l'onde élastique soit multimode entre chaque miroir de Bragg et le transducteur.

Dans un mode de réalisation, les miroirs de Bragg sont disposés à des distances d$_1$ et d$_2$ du transducteur comprises entre 0 et 10 fois la longueur d'onde V1/f1 de façon que la propagation de l'onde élastique soit monomode entre chaque miroir de Bragg et le transducteur.

Dans un mode de réalisation, le nombre N d'électrodes du transducteur est déterminé en fonction du coefficient de couplage k$_s$$^2$ et de la permittivité piézoélectrique équivalent $\varepsilon$ du substrat, avec N = G/($\omega$.k$_s$$^2$.4.$\varepsilon$.W) avec G la conductance de rayonnement égale en première approximation à l'inverse de la résistance motionelle du circuit équivalent de Butterworth-VanDyke, ω la pulsation et W l'ouverture acoustique ou longueur de recouvrement de deux électrodes de polarité opposée au sein du transducteur. Dans un mode de réalisation, la somme de la largeur d'électrodes du transducteur et de la largeur inter-électrodes du transducteur une période mécanique du réseau est comprise entre 2000 et 6000 m.s$^{-1}$ (soit la vitesse de phase du mode) divisé par $p_e/p_m$ fois la fréquence nominale de travail, avec $p_e$ la période de répétition du motif d'excitation électrique et $p_m$ la période de répétition de la structure mécanique des électrodes.

Dans un mode de réalisation, le rapport de largeur d'électrodes du transducteur sur largeur inter-électrodes de résonateur est compris entre 0,3 et 0,7.

Dans un mode de réalisation, le rapport épaisseur d'électrodes du transducteur sur longueur d'onde élastique λ = V1/f1 est compris entre 2,30 et 2,40%.

Dans un mode de réalisation, un nombre d'électrodes de miroir de Bragg est donné par la fonction N(|R|)= Partie entière (A/(B×|R| +C)) avec |R| l'efficacité de réflexion de chaque électrode, A = 1520, B=660 et C= 2,5×10$^{-2}$ pour que le coefficient de réflexion global du miroir dépasse 0,97, |R| étant compris entre 2,0×10$^{-3}$ et 2,5×10$^{-2}$.

Dans un mode de réalisation, la période de miroir de Bragg $p_{Bragg}$ est comprise entre V1/(2×f4) et V1/(2×$f_5$) avec f4-f5 la largeur de la bande interdite et la fréquence nominale de travail étant comprise dans cet intervalle ;

Dans un mode de réalisation, le rapport épaisseur d'électrodes de miroir de Bragg sur largeur inter-électrodes de miroir de Bragg est compris entre 0,5 et 0,7.

Dans un mode de réalisation, le rapport épaisseur d'électrodes de miroir de Bragg sur longueur d'onde élastique λ = V1/f1 est compris entre 2,35 et 2,45%.

Dans un mode de réalisation, la distance entre miroir de Bragg et transducteur est comprise entre 1,00 et 2,00 μm.

Dans un mode de réalisation, l'ouverture acoustique est comprise entre 200 et 400 μm. Dans un mode de réalisation, l'épaisseur d'électrodes est comprise entre 100 et 200 nm. Dans un mode de réalisation, le nombre d'électrodes du transducteur est compris entre 800 et 1000.

Dans un mode de réalisation, la somme de largeur d'électrodes du transducteur et de largeur inter-électrodes du transducteur est comprise entre 1,960 et 1,980 μm.

Dans un mode de réalisation, le rapport de largeur d'électrodes du transducteur sur largeur inter-électrodes du transducteur est compris entre 0,3 et 0,7.

Dans un mode de réalisation, le rapport épaisseur d'électrodes du transducteur sur longueur d'onde élastique λ = V1/f1 est compris entre 2,30 et 2,40%.

Dans un mode de réalisation, le nombre d'électrodes de miroir de Bragg est compris entre 100 et 200. Dans un mode de réalisation, la somme de largeur d'électrodes de miroir de Bragg et de largeur inter-électrodes de miroir de Bragg est compris entre 2,90 et 2,95.

Dans un mode de réalisation, le rapport épaisseur d'électrodes de miroir de Bragg sur largeur inter-électrodes de miroir de Bragg est compris entre 0,5 et 0,7.

Dans un mode de réalisation, le rapport épaisseur d'électrodes de miroir de Bragg sur longueur d'onde élastique λ = V1/f1 est compris entre 2,35 et 2,45%.

Dans un mode de réalisation, la distance entre miroir de Bragg et transducteur est comprise entre 1,00 et 2,00 μm.

Dans un mode de réalisation, l'ouverture acoustique est comprise entre 200 et 400 μm.

Dans un mode de réalisation, l'épaisseur d'électrodes est comprise entre 100 et 200 nm. Dans un mode de réalisation, le dispositif comprend un résonateur présentant une dérive thermique négative de la vitesse de phase, de façon que l'écart entre les pics diminue selon la température de manière identique à la loi fréquence-température caractérisant le mode de surface, la mesure de température déduite dudit écart étant naturellement différentielle.

Dans un mode de réalisation, le résonateur et les miroirs de Bragg présentent un recouvrement spectral, le coefficient de réflexion unitaire des miroirs de Bragg étant supérieur à 1,5% avec 150 électrodes ou plus pour atteindre un pouvoir réflecteur de 0,975 ou plus, et le coefficient de réflexion unitaire des miroirs de Bragg étant compris entre 0,5 et 1% avec 300 électrodes ou plus pour atteindre un pouvoir réflecteur de 0,99 ou plus.

D'autres caractéristiques et avantages de l'invention apparaîtront à l'examen de la description détaillée ci-après, et des dessins annexés, sur lesquels :

- la figure 1 illustre la variation de la conductance en fonction de la fréquence mesurée à plusieurs températures pour un résonateur à ondes élastiques de surface à deux doigts par longueur d'onde $λ_{ac}$ (2d/$λ_{ac}$),
- les figures 2a et b illustrent la variation de la susceptance en fonction de la fréquence mesurée à plusieurs températures, et de la directivité et du coefficient de réflexion en fonction de la température pour un transducteur périodique infini à ondes élastiques de surface à deux doigts par longueur d'onde $λ_{ac}$ (2d/$λ_{ac}$),,
- les figures 3a et b illustrent la variation de l'admittance d'une onde de Rayleigh en fonction de la fréquence mesurée à plusieurs températures pour un transducteur périodique infini à ondes élastiques de surface hors bande de Bragg, pour deux bandes de fréquence,

- la figure 4 illustre un exemple d'électrodes de transducteur à 3 doigts par longueur d'ondes,
- la figure 5 illustre un exemple d'électrodes de transducteur à 4 doigts par longueur d'ondes,
- la figure 6 est une vue de dessus d'un exemple d'électrodes de transducteur à ondes élastiques de surface fonctionnant hors de la bande de Bragg,
- la figure 7 illustre la variation de la susceptance harmonique et de la partie imaginaire du nombre d'ondes pour un transducteur périodique infini à ondes élastiques de surface à réseau à trois doigts par longueur d'ondes ($3d/\lambda_{ac}$) et bande d'arrêt à 2 doigts par longueur d'ondes ($2d/\lambda_{ac}$) en fonction de la période de répétition des électrodes,
- les figures 8 à 10 illustrent la variation du coefficient de réflexion $S_{11}$ - module et angle de phase -, de la conductance et de la susceptance pour trois résonateurs à ondes élastiques de surface à transducteurs comptant trois doigts par longueur d'ondes ($3d/\lambda_{ac}$), le premier ayant une fréquence de résonance au bord de la bande de Bragg, le second ayant une fréquence de résonance entre bord et centre de la bande de Bragg, le troisième ayant une fréquence de résonance au centre de la bande de Bragg,
- les figures 11a à 11c illustrent le rapport résonance/anti-résonance pour chaque configuration (a) bord de bande d'arrêt (b) entre bord et centre de bande d'arrêt (c) au centre de bande d'arrêt,
- la figure 12 illustre un exemple d'électrodes de transducteur à 5 doigts pour 2 longueurs d'ondes ($5d/2\lambda_{ac}$) et excitation en +V/-V/-V/+V/-V,
- la figure 13 illustre la réponse électrique du transducteur périodique infini à 5 doigts pour deux longueurs d'ondes ($5d/2\lambda_{ac}$) selon la configuration de la figure 12, (a) conductance et susceptance harmoniques, (b) module de l'admittance et module de l'impédance harmoniques,
- la figure 14 illustre le module de l'admittance en fonction de la température du transducteur de la figure 12,
- la figure 15 illustre un exemple d'électrodes de transducteur à 7 doigts pour 3 longueurs d'ondes ($7d/3\lambda_{ac}$) et excitation en +V/-V/+V/+V/-V/+V/-V,
- la figure 16 illustre l'admittance harmonique G+jB du transducteur périodique infini à 7 doigts pour 3 longueurs d'onde selon la configuration de la figure 15,
- la figure 17 illustre un exemple d'électrodes de résonateur à 8 doigts pour 3 longueurs d'ondes ($8d/3\lambda_{ac}$) et excitation en 0/-V/+V/-V/0/+V/-V/+V,
- la figure 18 illustre l'admittance harmonique G+jB du transducteur périodique infini à 7 doigts pour 3 longueurs d'onde selon la configuration de la figure 17,
- la figure 19 illustre la réponse en réflexion ($S_{11}$) d'un résonateur multimode sur langasite avec plusieurs contributions dans la bande ISM, coupe (YXlt)/48,5°/26,7° avec une structure d'espaces(gaps) non symétrique ($g_1$=1987 $\mu$m, g2=1988,3 $\mu$m), 150 électrodes dans les miroirs, métallisation en platine de 142 nm d'épaisseur, ouverture acoustique égale à 300 $\mu$m,
- la figure 20 illustre l'évolution de la réponse d'un résonateur asymétrique selon le Tableau 2) à électrodes de Pt sur LGS (YXlt)/46.5°/26.7° à deux températures différentes,
- la figure 21 illustre la réponse en réflexion ($S_{11}$) d'un résonateur multimode sur langasite avec plusieurs contributions dans la bande ISM, coupe (YXlt)/48,5°/26,7° avec une structure de gaps symétrique (g=987,6 $\mu$m), 200 électrodes dans les miroirs, métallisation en platine de 118 nm d'épaisseur, ouverture acoustique 300 $\mu$m,
- la figure 22 illustre la réponse en admittance du transducteur à $3d/\lambda_{ac}$ du résonateur multimode de la figure 21, métallisation en platine de 118 nm d'épaisseur, période 1,989 $\mu$m, 100 longueurs d'onde, ouverture acoustique 300 $\mu$m, comparaison entre calcul de matrice mixte et expression littérale de la conductance de rayonnement,
- la figure 23 illustre la réponse en admittance du transducteur du résonateur multimode de la figure 21, métallisation en platine de 118 nm d'épaisseur, ouverture acoustique 300 $\mu$m, et
- la figure 24 montre une cartographie de la fonction de réflexion d'un miroir à électrodes distribuées périodiquement selon le nombre d'électrodes et l'intensité du coefficient de réflexion unitaire.

Les dessins annexés pourront non seulement servir à compléter l'invention, mais aussi contribuer à sa définition, le cas échéant.

Les systèmes de mesure sans fil à base de dispositifs à ondes élastiques de surface comprennent généralement un système d'interrogation comprenant des organes d'émission/réception d'ondes radiofréquences associées à un traitement de données et au moins un transpondeur à ondes élastiques de surface. Un dispositif à ondes élastiques de surface peut comporter un ou plusieurs transpondeurs à résonateurs. Un transpondeur comporte une antenne et un transducteur à peignes d'électrodes inter-digitées et une cavité résonante décrite par sa fréquence centrale et son facteur de qualité. La cavité comprend deux séries de réflecteurs régulièrement espacés d'une distance choisie.

Il existe des fréquences de résonance pour lesquelles le trajet retour dans la cavité est égal à un nombre entier de longueurs d'ondes. Les modes de résonance pour ces fréquences sont excités par le transducteur placé entre les miroirs. Ce type de capteurs peut être interrogé à distance, en reliant l'entrée du transducteur à une antenne radiofréquence. Lorsque l'antenne reçoit un signal électromagnétique, le signal reçu provoque des ondes à la surface du substrat, ondes converties en énergie électromagnétique sur l'antenne. Ainsi, le dispositif constitué d'un ensemble de résonateurs, connectés à une antenne, a une réponse aux fréquences de résonance des résonateurs qu'il est possible de mesurer à distance. D'où la possibilité de réaliser des capteurs interrogeables à distance. Ceci trouve une application intéressante dans le domaine des capteurs de température et de pression pour pneumatiques, le capteur étant disposé dans le pneumatique alors que le dispositif électronique d'interrogation est embarqué à bord du véhicule, indépendamment donc de la rotation du pneumatique.

Le système d'interrogation ainsi que le capteur à ondes élastiques de surface sont munis respectivement d'antennes, adaptées à la bande de fréquence de travail (bande ISM 433 MHz, 868 MHz, 2,45 GHz,...) ou à toute autre bande de fréquence libre d'utilisation, ce qui permet d'effectuer l'interrogation sans fil du capteur.

Le mode d'interrogation est le suivant : l'émetteur du système d'interrogation envoie un signal d'interrogation (impulsion temporelle d'un porteur dans la bande ISM, plage temporelle d'émission) vers l'antenne associée au résonateur à ondes élastiques de surface. Par effet de couplage électromagnétique, l'onde électromagnétique incidente est transformée en une onde élastique se propageant à la surface du substrat. Si le signal d'émission présente une fréquence de résonance suffisamment proche de la fréquence propre du résonateur à ondes élastiques de surface, ce dernier entre en résonance en passant par une période de charge. Il s'établit alors un régime permanent d'oscillations à la fréquence de résonance propre du dispositif à ondes élastiques de surface. La fréquence de résonance f1 du résonateur est proportionnelle à la vitesse V1 de l'onde de surface dans la cavité résonante qui dépend elle-même de la température et des contraintes vues par le résonateur.

On rappelle que la variation de la fréquence de résonance d'un résonateur à ondes élastiques de surface sur quartz en fonction de la température est généralement déterminée par la formule suivante : $f(T) = f_0[1+CTF_1(T-T_0) + CTF_2(T-T_0)^2]$ avec $T_0$ la température de référence (25°C par convention), $f_0$ la fréquence à $T_0$, CTF1 le coefficient du premier ordre en ppm/°C et CTF2 le coefficient du second ordre en ppb/°C$^2$.

La loi de variation de la fréquence de résonance en fonction de la température est donc généralement approchée de façon précise à l'aide d'une parabole. La température à laquelle la fréquence est maximale (sommet de la parabole) est appelée température d'inversion de la loi fréquence-température.

De manière générale, un résonateur possède une fréquence de résonance propre que l'on définit comme la fréquence du maximum de la conductance. Cette fréquence correspond d'une part à la fréquence à laquelle le résonateur se décharge lorsqu'il est en régime dit libre et d'autre part, à la fréquence à laquelle le résonateur admet un maximum de puissance lorsque soumis à une tension sinusoïdale. Lorsque l'on connecte un élément (antenne, inductance, capacitance, résistance ou une combinaison des trois précédents) en série ou en parallèle au résonateur, la fréquence de résonance de l'ensemble est alors en général différente de celle du résonateur seul.

Dans le domaine des capteurs à ondes élastiques de surface interrogeables à distance fondés sur résonateurs simple port, la structure du dispositif consiste en un transducteur excitant généralement des ondes de Rayleigh (à polarisation majoritairement elliptique), entouré de deux miroirs de Bragg.

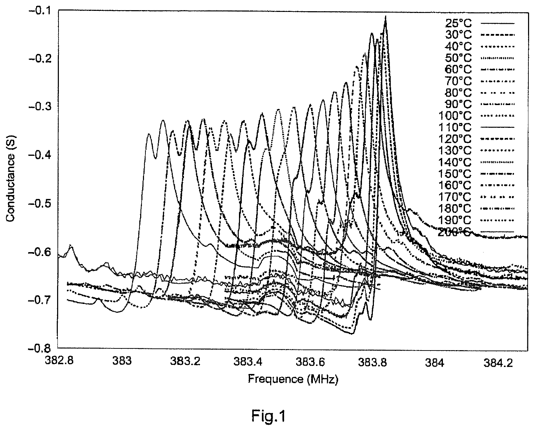

D'après les mesures effectuées par la demanderesse, les propriétés du transducteur peuvent évoluer en fonction de conditions paramétriques auxquelles le résonateur est soumis. Plus particulièrement, les transducteurs à deux doigts par longueur d'onde, fonctionnant auxdites conditions de Bragg peuvent voir leurs propriétés de directivité modifiées lors d'une évolution de paramètres telle qu'une variation de température ou de contraintes mécaniques. Ceci entraîne alors une distorsion de la réponse électrique et peut engendrer des difficultés d'interprétation des mesures voire des erreurs dues à des sauts de fréquence lors de la phase de détection. Un tel phénomène est mis en évidence sur la figure 1 où l'on voit l'évolution de la réponse d'un résonateur synchrone simple port à ondes de Rayleigh en fonction de la température sur un substrat de langasite de coupe (YX/t)/48,5°/26,7° mesurée expérimentalement. Plus particulièrement, on remarque que la courbe de la réponse du résonateur à température ambiante présente un seul pic d'où une réponse univoque. La courbe mesurée à la température de 150° présente un pic majeur et un pic mineur. Les courbes correspondant aux températures 160, 178, 180 et 190 et 200°C présentent des pics pratiquement égaux rendant extrêmement difficile l'interprétation de la réponse. Ainsi, à une conductance de 0,4 S à 200° correspondent plusieurs fréquences.

Il existe donc un besoin de pallier ce problème.

La demanderesse a cherché et mis au point une solution pour laquelle la réponse électrique du résonateur subit de moindres distorsions, notamment en présentant une fréquence de résonance à évolution continue en fonction des paramètres environnementaux comme la température, la contrainte, l'accélération, la pression et, plus généralement toute grandeur physique susceptible d'affecter le résonateur et d'être mesurée par suivi de la fréquence de résonance du résonateur. On entend ici par évolution continue, le fait que la courbe conductance/fréquence présente un maximum unique dans la bande fréquentielle utile.

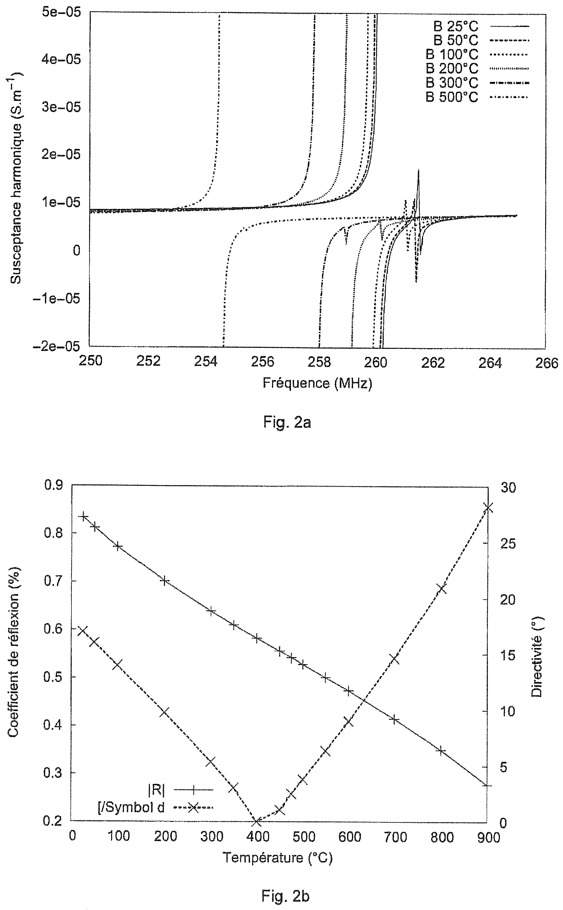

Il a en effet été identifié que le problème de directivité est lié au fait que pour une coupe quelconque de matériau piézoélectrique, le synchronisme des ondes peut engendrer une contribution en entrée et en sortie de bande d'arrêt, donnant lieu à une réponse spectrale multimode. La figure 2 illustre ce phénomène pour la même coupe que la figure 1. Ce phénomène s'avère présent dans les matériaux piézoélectriques sur lesquels des ondes élastiques peuvent être excitées par un transducteur inter-digité.

L'invention tient compte du fait que seules les ondes de Rayleigh se propageant sur coupes à simple rotation de matériaux monocristallins selon l'axe X ne sont pas assujetties à ce phénomène de directivité, plus particulièrement pour des structures synchrones sans espace décalant la résonance au sein de la bande d'arrêt du miroir. L'invention permet en effet d'exploiter n'importe quelle coupe de matériau piézoélectrique pour obtenir des résonateurs de pureté spectrale maîtrisée, notamment les coupes dont la propagation n'est pas colinéaire à l'axe cristallin du matériau, en particulier les coupes présentant un angle de flux d'énergie inférieur à 2° en valeur absolue.

Les figures 2a et 2b montrent une estimation de l'évolution de la directivité et des propriétés de réflectivité d'ondes de Rayleigh sous réseau d'électrodes en platine sur coupe (YX*lt*)48,5°/26,7° de langasite. La figure 2a montre l'admittance harmonique pour plusieurs températures et la figure 2b montre le module du coefficient de réflexion |R| et la directivité δ. La figure 2b met en relief le fait que la directivité - un angle pouvant s'exprimer en degrés - peut s'annuler à certaines températures mais aussi passer très largement au-dessus de sa valeur à température ambiante. La demanderesse y observe également que le coefficient de réflexion des ondes sur électrodes de platine s'effondre aux températures supérieures à 300°. Ceci explique la difficulté à maintenir une réponse électrique constante sur la gamme de température, en dehors des pertes intrinsèques des matériaux lesquels augmentent généralement avec la température.

La demanderesse a mis au point une structure d'électrodes de transducteur fonctionnant hors de la bande fréquentielle interdite des miroirs de Bragg. Le maintien est obtenu sur la gamme paramétrique à laquelle le résonateur est assujetti, d'une réponse électrique maîtrisée, reproductible et présentant une monotonie de la variation de fréquence en fonction du paramètre d'intérêt. Les sauts de fréquence intempestifs dus à l'évolution de la réponse électrique sont évités.

En effet, une structure de transducteur hors condition de Bragg n'est pas assujettie au problème de directivité, phénomène lié au fait que pour une coupe quelconque de matériau piézoélectrique, le synchronisme des ondes élastiques peut engendrer une contribution en entrée et en sortie de bande d'arrêt, donnant lieu à une réponse spectrale multimode.

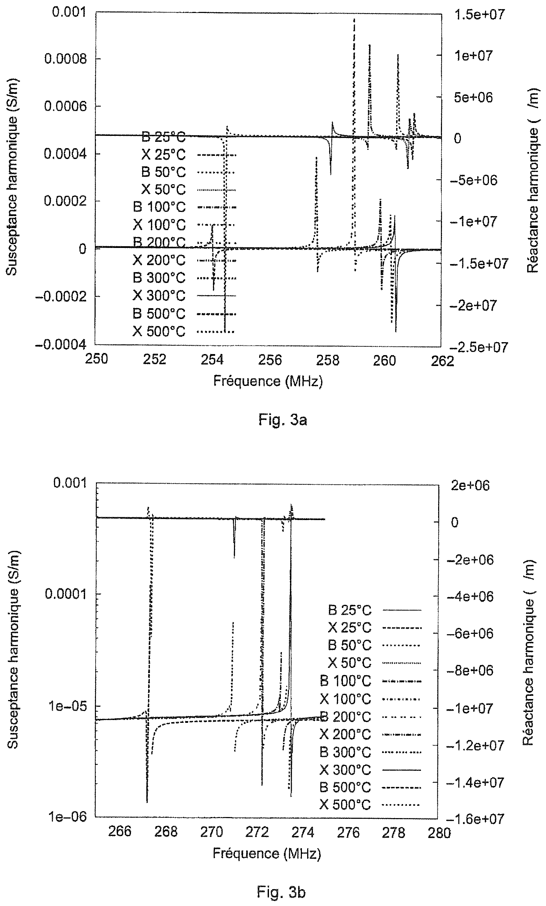

Dans le cas d'une structure de transducteur fonctionnant hors de la bande fréquentielle interdite des miroirs de Bragg, ou bande de Bragg, le synchronisme existe bien pour deux conditions de phase/fréquence mais la sortie (ou l'entrée) de bande d'arrêt est inhibée par rapport à la condition de Bragg. Ceci se produit à une fréquence notablement éloignée (vers les fréquences hautes ou basses) de la bande interdite f4-f5 des miroirs de Bragg. Dans ces conditions, les miroirs laissent passer les ondes en phase et le phénomène de résonance est négligeable.. La figure 3 montre l'évolution de l'admittance d'une onde de Rayleigh sur coupe (YX*lt*)/48,5°/26,7° de langasite sous réseau périodique infini de platine (analyse harmonique) pour 3 doigts par longueur d'ondes (paramètre d'excitation égal à 1/3) avec en (a) la contribution principale "basse" fréquence et en (b) la contribution marginale haute fréquence.

La figure 3 illustre ce phénomène pour la coupe de langasite prise comme support de comparaison mais avec un résonateur à trois doigts par longueur d'onde. D'une part la contribution haute fréquence est nettement éloignée de la contribution basse fréquence ici recherchée. D'autre part la contribution haute fréquence présente un couplage électromécanique quasiment nul et ce pour toutes les températures considérées ici, de 25 à 500°C. De plus, la forme complexe de l'admittance à ce point de fonctionnement et son évolution en température montrent qu'il faut écarter toute contribution du transducteur liée à ce point de fonctionnement. La structure à 3 doigts par longueur d'ondes permet d'éliminer l'effet de directivité, grâce au fonctionnement en dehors des conditions de Bragg.

Ainsi, ce type de transducteur est mis en œuvre pour l'excitation et la détection des ondes. Un piège à ondes est formé par un miroir de Bragg ; en d'autre termes, un réseau d'électrodes tel que sa période mécanique soit deux fois plus petite que la longueur d'onde de l'onde de Rayleigh excité par le transducteur. La conception d'un résonateur combinant un transducteur hors condition de Bragg et des miroirs de Bragg présente des différences par rapport à celle d'un résonateur pour lequel la condition de Bragg est respectée partout. Ici, on cherche à optimiser la position du pic de résonance dans la bande d'arrêt. On peut établir des critères robustes de conception en comparant l'étendue de la réponse électrique du transducteur et la couverture spectrale du miroir. Le but est alors de positionner les zéros d'excitation latéraux (la fonction de transfert du transducteur suit une loi en sin*x*/*x*, les zéros en question étant les points d'annulation de la fonction autour de la fréquence centrale, *x* prend ici une valeur égale à $(\omega-\omega_0)t$ avec $\omega_0$ la pulsation de synchronisme, pour laquelle l'excitation des ondes de Rayleigh est maximale) du transducteur sur les maximums de réflexion latéraux des miroirs de Bragg. L"invention tire parti de la stabilité opératoire du transducteur fonctionnant hors de la condition de Bragg.

Des structures correspondant à cette définition sont les transducteurs à 3 et 4 doigts par longueur d'ondes, entre autres. De telles électrodes peuvent être utilisées à des fréquences compatibles avec les contraintes technologiques actuelles. Pour une résolution de lithographie optique UV de l'ordre de 0,35 μm, la limite de fréquence de travail avec une onde de Rayleigh se propageant à 2600 m.s$^{-1}$ est de 928 MHz, soit 915 MHz en considérant une garde technologique et une fréquence correspondant à une application réelle (bande ISM nord-américaine). Il est donc souhaitable de disposer de structures permettant de travailler à plus hautes fréquences ou au moins de faciliter les opérations technologiques avec une surface d'électrodes plus importante.

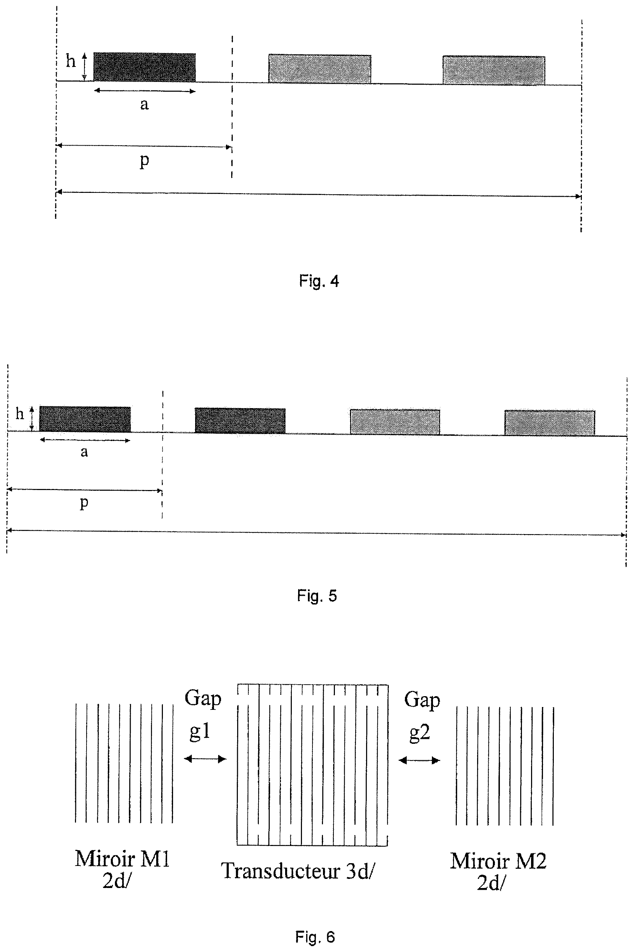

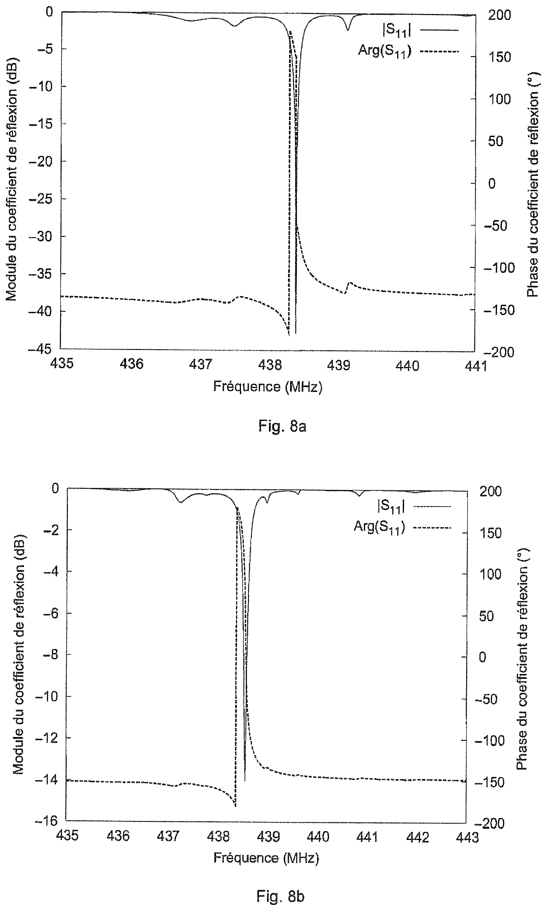

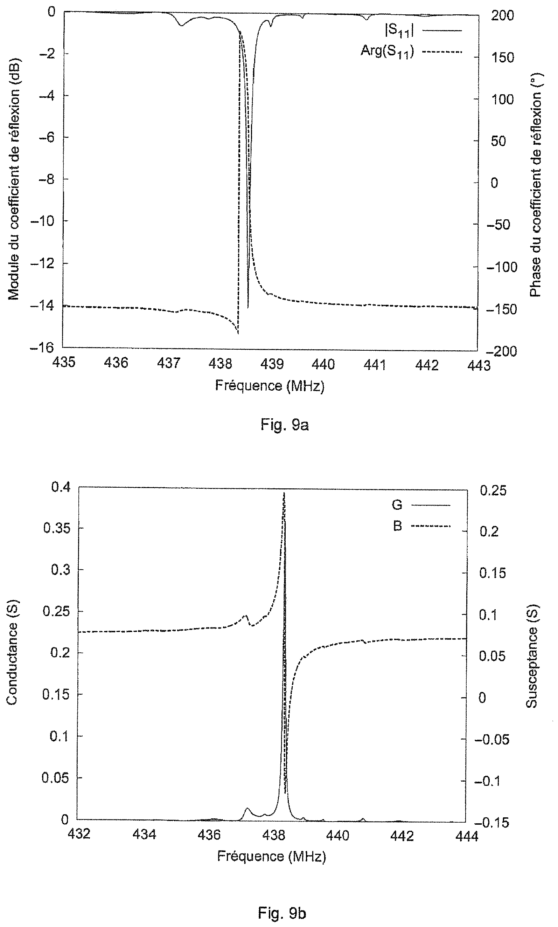

Un résonateur utilisé comme élément de capteur de grandeurs physiques interrogeable à distance peut être constitué dudit transducteur fonctionnant hors de la bande de Bragg et de deux miroirs à la condition de Bragg, illustré en figure 4. Dans ce type de structure, la bande d'arrêt du transducteur est ajustée par rapport à la bande d'arrêt du miroir pour fournir la meilleure réponse électrique au sens de la pureté spectrale. Plusieurs points de fonctionnement sont envisageables comme le montre les figures 8 à 10, allant du positionnement de la fréquence de synchronisme au centre de la bande d'arrêt (structure de type Hiccup, voir P.V. Wright, A review of SAW resonator filter technology, Proc. of the IEEE Ultrasonics Symposium, vol.1, pp.29-38, 1992) ou en entrée de bande d'arrêt (comme dans le cas d'un résonateur purement synchrone). La conception d'un tel résonateur passe par la prise en compte précise du rôle spectral joué par chaque élément de la structure. Les tests numériques montrent que l'introduction d'espaces (« gap ») entre les miroirs et le transducteur permet de décaler finement en fréquence le phénomène de synchronisme par rapport au miroir et à son optimum de réflexion. Une optimisation de haut niveau peut être obtenue. Lesdits espaces minimisent les pics parasites dont l'amplitude est ici maintenue inférieure à la moitié de la réponse principale pour éviter toute interférence indésirable. Dans les configurations ci-après, n'a été considéré qu'un seul espace $g_1$ pour optimiser la réponse électrique, la combinaison de deux espaces revenant au même qu'un seul espace, au moins en première estimation.

Les miroirs de Bragg peuvent être réalisés par dépôt métallique comme le transducteur ou par gravure d'un substrat ou toute autre approche permettant de réaliser des réseaux gravés aux conditions de Bragg. Les miroirs de Bragg peuvent être disposés à des distances $d_1$ et $d_2$ du transducteur comprises entre 0 et 10 fois la longueur d'onde V1/f1, avec f1 la fréquence de synchronisme du transducteur, de façon que la propagation de l'onde élastique soit monomode entre chaque miroir de Bragg et le transducteur. La distance nulle correspond à une variante dans laquelle au moins un des espaces $g_1$, $g_2$ est nul, soit $d_1 = 0$ et/ou $d_2 = 0$.

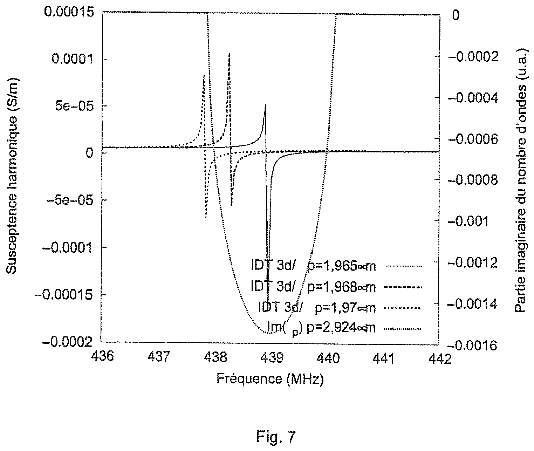

La figure 7 montre les différentes coïncidences entre la réponse électrique harmonique du réseau du transducteur à 3 doigts par longueur d'onde $\lambda$ et de la bande d'arrêt du réseau des miroirs de Bragg à 2 doigts par longueur d'onde $\lambda$ en fonction de la période de répétition des électrodes. On y montre la susceptance harmonique dont le changement de signe brutal matérialise la condition spectrale de synchronisme, exprimée en S m$^{-1}$ pour trois points de fonctionnement par rapport à la partie imaginaire du vecteur d'onde normalisé $\gamma$, cette partie imaginaire traduisant l'atténuation des ondes le long du miroir selon une loi en $e^{j\frac{2\pi}{p}\gamma x}$ avec $p$ la période du réseau et $x$ la variable d'espace selon laquelle le réseau se développe.

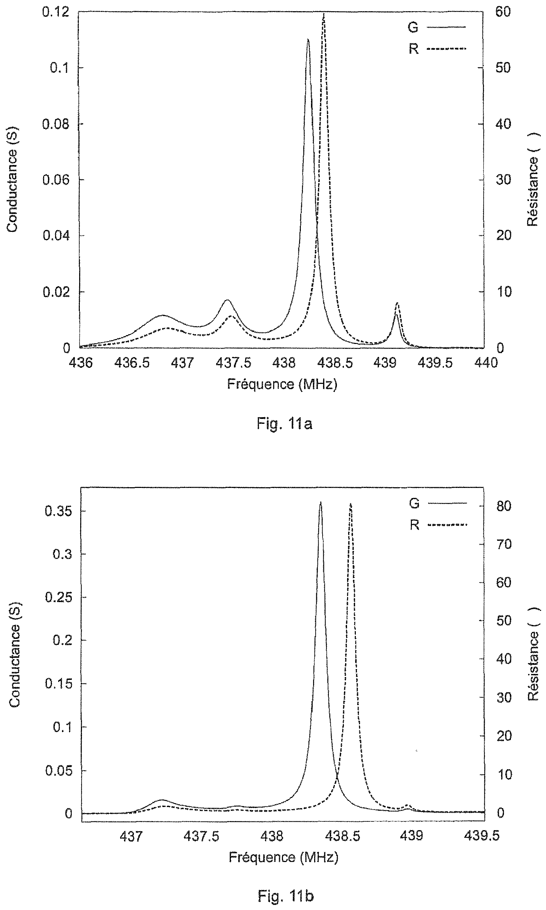

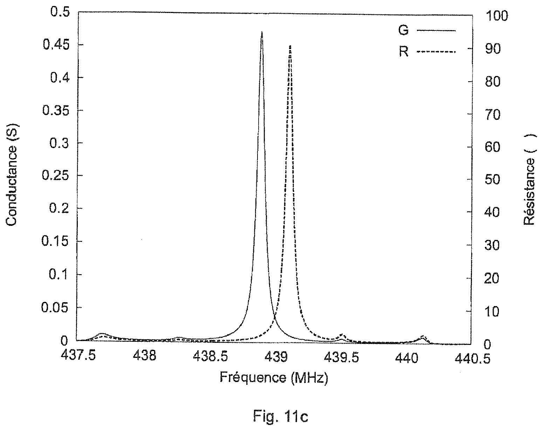

En figures 8, 9 et 10 sont considérés trois cas typiques pour lesquels le synchronisme du transducteur se situe respectivement en limite basse de bande d'arrêt des miroirs de Bragg, au milieu de la bande d'arrêt et dans une situation intermédiaire entre entrée et milieu de bande d'arrêt. Les figures 8a, 9a et 10a montrent l'évolution du coefficient de réflexion $S_{11}$ du résonateur représenté en module $|S_{11}|$ et en phase Arg($S_{11}$). Les figures 8b, 9b et 10b montrent l'évolution de l'admittance complexe Y = G + jB du résonateur représentée en partie réelle la conductance G et en partie imaginaire la susceptance B. La figure 11 montre le rapport résonance/anti-résonance pour chaque configuration (a) au bord de la bande d'arrêt, (b) entre le bord et le centre de la bande d'arrêt, et (c) au centre de la bande d'arrêt.

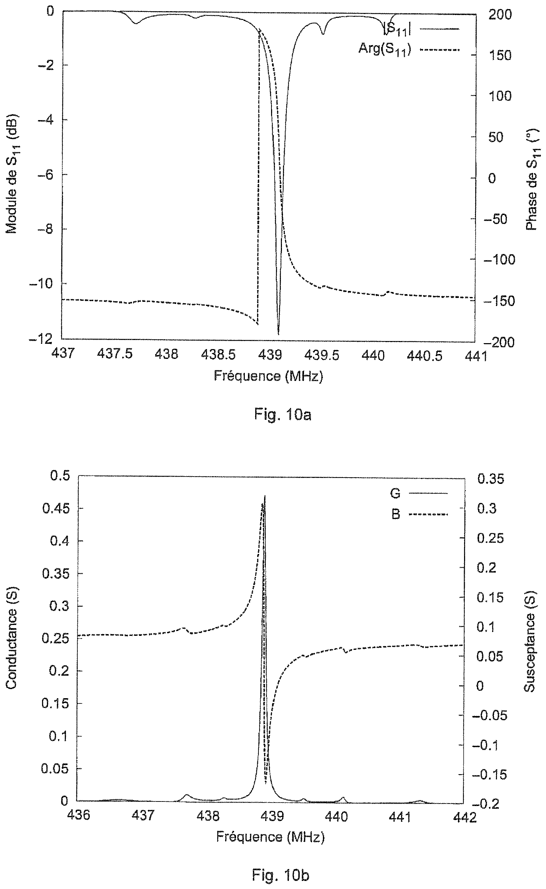

Comme illustré sur les figures 8 à 11, il est possible, malgré un couplage électromécanique plus faible que pour des structures fonctionnant complètement à la fréquence de Bragg (ici 1‰ contre 2,5‰ en structure fonctionnant de façon homogène à la condition de Bragg), de réaliser un résonateur opérationnel et répondant aux critères de pureté spectrale requis pour une application de capteur. Si la structure de la figure 8 fonctionnant en bord inférieur de bande d'arrêt présente la plus grande dynamique en termes de module de coefficient de réflexion $|S_{11}|$ exprimé en dB, la structure de la figure 10 fonctionnant au centre de la bande d'arrêt offre le meilleur rapport entre modes parasites et pic principal et présente le meilleur couplage électromécanique.

Il existe donc un optimum selon que l'on cherche à favoriser tel ou tel paramètre du résonateur et de sa réponse électrique, soit les degrés de liberté de l'optimisation. L'optimisation est circonstanciée en fonction des choix de conception, tel que nombres d'électrodes dans les miroirs et dans le transducteur, rapport de surfaces métallisée et libre par période et épaisseur de métallisation, orientation cristalline, etc.

Le coefficient de qualité obtenu, en figure 11, est de l'ordre de 2500 calculé sur la conductance G comme la fréquence centrale du pic divisée par sa largeur à mi-hauteur. Le coefficient de qualité est lié à la longueur du résonateur et plus particulièrement à la longueur des miroirs et au faible pouvoir réflecteur du platine sur les ondes de Rayleigh pour ce matériau et cette coupe de langasite en particulier. Le platine a été considéré à titre d'exemple. Il présente l'inconvénient de la chute du module de coefficient de réflexion avec la température. Cela signifie aussi que les configurations décrites ici peuvent de ne pas donner les résultats les plus élevés en termes d'évolution de la résonance avec la température. Mais lesdites configurations conserveront une résonance principale dont le comportement de la fréquence de résonance en température restera continu (pas de saut de mode). La continuité de ce comportement en température est prioritaire sur la chute de l'amplitude de la résonance. La figure 11 compare les rapports résonance/antirésonance pour chaque configuration à température ambiante. Le tableau 1 récapitule les configurations d'électrode et de gap adoptées pour chaque résonateur simulé précédemment.

Tableau 1: Paramètres technologiques de conception des trois dispositifs

| Paramètres | Dispositif fig.8 | Dispositif fig.9 | Dispositif fig.10 |
|---|---|---|---|
| Nbre d'électrodes IDT | 900 | 900 | 900 |
| Période IDT ($\mu$m) | 1,97 | 1,968 | 1,965 |
| Rapport a/p IDT | 0,5 | 0,5 | 0,5 |
| Rapport h/$\lambda$ IDT (%) | 2,369 | 2,371 | 2,375 |
| Nbre d'électrodes Miroir | 150 | 150 | 150 |
| Période Miroir ($\mu$m) | 2,924 | 2,924 | 2,924 |
| Rapport a/p Miroir | 0,53 | 0,53 | 0,53 |
| Rapport h/$\lambda$ Miroir (%) | 2,394 | 2,394 | 2,394 |
| Espace $g_1$ ($\mu$m) | 1,15 | 1,8 | 1,8 |
| Ouverture acoustique ($\mu$m) | 300 | 300 | 300 |
| Épaisseur d'électrode (nm) | 140 | 140 | 140 |

La fréquence f2 peut être égale à 657 MHz. La fréquence f2 peut être égale à 660,5 MHz. La fréquence f4 peut être égale à 438 MHz. La fréquence f5 peut être égale à 440 MHz. La fréquence f6 peut être égale à 439 MHz. La fréquence f7 peut être égale à 439 MHz.

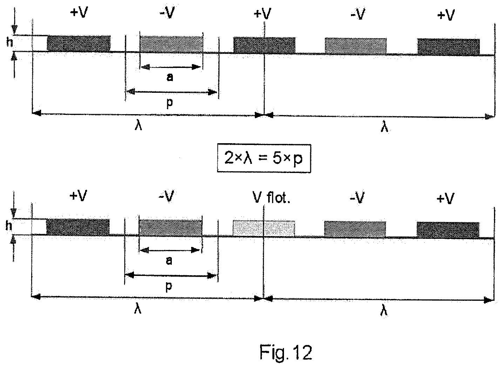

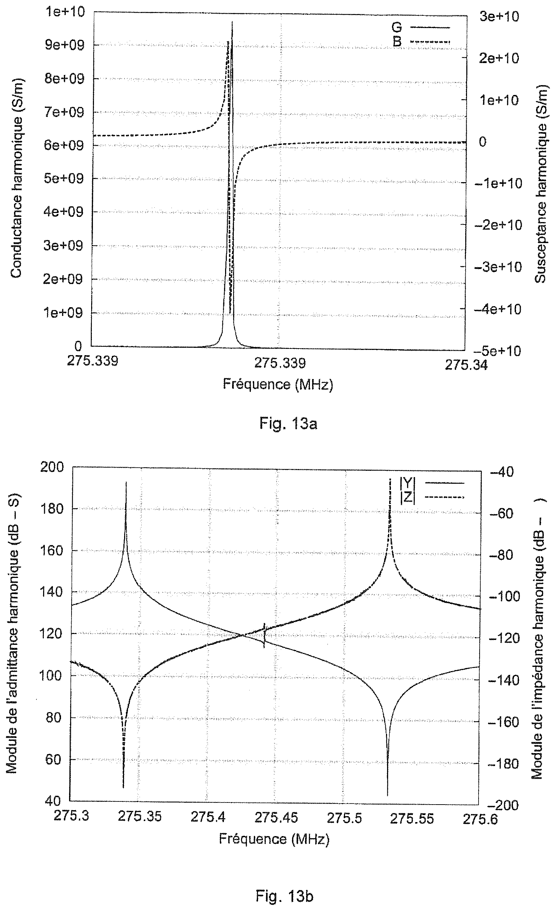

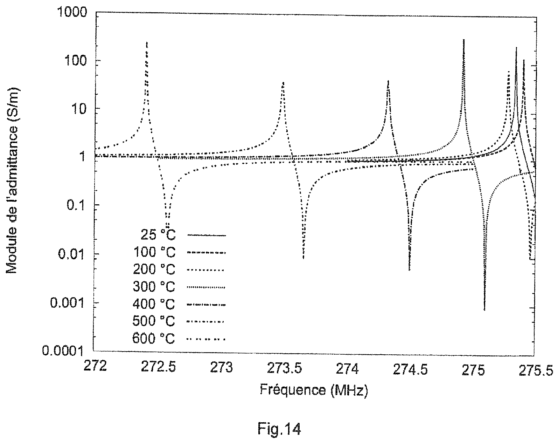

Plusieurs structures de transducteur fonctionnant hors de la condition de Bragg sont opératoires pour l'application visée. Au moins trois structures ont été mises au point. Une structure consiste en 8 électrodes pour 3 longueurs d'ondes, ce qui place à des conditions de travail en nombre d'onde de $3\pi/4\lambda$. Une structure consiste en 7 électrodes pour 3 longueurs d'ondes, ce qui place à des conditions de travail en nombre d'onde de $6\pi/7\lambda$ (la condition de Bragg correspond à un nombre d'ondes de $\pi/\lambda$). Une structure à 5 électrodes pour deux longueurs d'ondes a également été mise au point correspondant à un nombre d'ondes de $4\pi/5\lambda$. En termes de coefficient de périodicité $\gamma$ pour l'analyse harmonique décrit dans l'article de S. Ballandras, A. Reinhardt, V. Laude, A. Soufyane, S. Camou, W. Daniau, T. Pastureaud, W. Steichen, R. Lardat, M. Solal, P. Ventura, "Simulations of surface acoustic wave devices built on stratified media using a mixed finite element/boundary element intégral formulation", Journal of Applied Physics, vol. 96, N°12, pp.7731-7741, 2004, auquel le lecteur est invité à se reporter, ces trois conditions correspondent à 0,375, 0,429 et 0,4. La figure 12 montre une configuration d'excitation possible pour la structure à 5 doigts pour deux longueurs d'ondes et la figure 13 montre les propriétés de cette structure. Le principe peut être formellement étendu à toute combinaison d'électrodes entraînant un écart par rapport à la fréquence de Bragg mais il est toutefois apparu au cours des simulations que plus le nombre d'électrodes consécutives se rapprochait d'une figure périodique stricte d'excitation (alternance +V/-V), plus la contribution à haute fréquence apparaît et les pertes à la fréquence de synchronisme augmentent. Les structures proposées ci-après peuvent être donc considérées comme particulièrement efficaces en fonctionnement. La structure de transducteur à 5 doigts pour deux longueurs d'ondes (figure 12) présente une configuration d'excitation : +V/-V/+V/+V/-V La configuration d'excitation +V/-V/flottant/+V/-V est une variante. Une autre configuration d'excitation fondée sur l'alternance de potentiel positif, négatif ou flottant permettant une excitation efficace du mode de Rayleigh peut convenir. La figure 14 montre pour une coupe (YX*lt*)/48,5°/26,7° de langasite, un coefficient de qualité de plus de 100 000 (pertes minimes), un coefficient de couplage électromécanique est de 0,14%. La contribution haute fréquence entre résonance et anti-résonance du mode de Rayleigh n'est pas couplée.

Le calcul pour la configuration à 5 doigts pour deux longueurs d'onde sur coupe (YX*lt*)/48,5°/26,7° de langasite montre en tout état de cause l'opérabilité de la structure et en particulier la pureté spectrale du pic de synchronisme en fonction de la température. Le transducteur peut donc être avantageusement utilisé en lieu et place du transducteur à 3 doigts par longueur d'ondes, offrant plus de facilité de réalisation en termes technologiques.

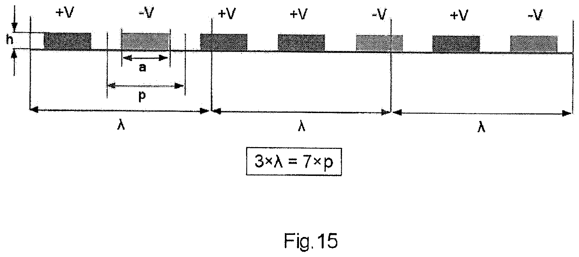

La configuration de réseau périodique à 7 doigts pour 3 longueurs est reportée en figure 15 pour la coupe de quartz (YXwlt)/-20°/-36,5°/+20°, illustrant l'un des modes d'excitation envisageables. La structure de transducteur à 7 doigts pour trois longueurs d'ondes présente une configuration d'excitation : +V/-V/+V/+V/-V/+V/-V. La configuration d'excitation +V/-V/+V/flottant/-V/+V/-V est une variante. Là encore, le synchronisme montre une contribution principale exploitable et une contribution secondaire très faiblement couplée.

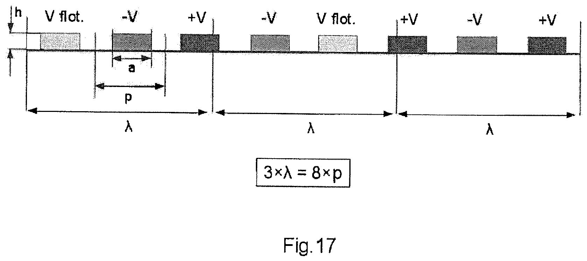

La configuration de réseau périodique à 8 doigts pour 3 longueurs est reportée en figure 17 pour la coupe de quartz (YX*wlt*)/-20°/-36,5°/+20°, illustrant l'un des modes d'excitation envisageables. La structure de transducteur à 8 doigts pour trois longueurs d'ondes présente une configuration d'excitation : Flottant/-V/+V/-V/flottant/+V/-V/+V. La configuration d'excitation +V/-V/+V/-V/+V/+V/-V/+V est une variante. Là encore, le synchronisme montre une contribution principale exploitable et une contribution secondaire très faiblement couplée.

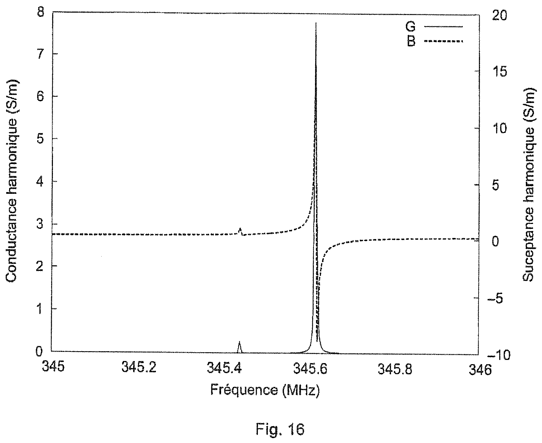

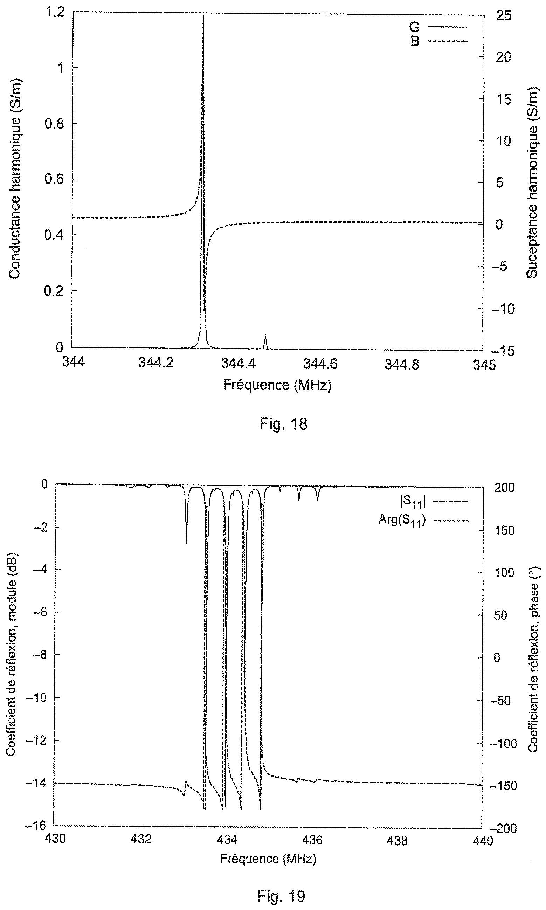

Suivant les propriétés de symétrie du substrat et le point de fonctionnement choisi, la contribution la mieux couplée peut se trouver en position haute ou basse dans le plan de fréquence comme le montre les figures 16 et 18.

La combinaison d'un transducteur fonctionnant hors de la condition de Bragg et de miroirs de Bragg constitue une approche robuste pour des capteurs susceptibles de voir leur réponse altérée notablement par les modifications de l'environnement auxquelles ils sont assujettis. L'invention permet d'éviter le saut d'un mode à un autre lié, en particulier, à la modification des propriétés de directivité du transducteur lors du fonctionnement à la condition de Bragg. Par ailleurs, l'utilisation de ce type de transducteur sur quartz ou autre matériau piézoélectrique permet de généraliser l'utilisation de transducteurs fonctionnant hors de la condition de Bragg et une surface d'électrode nettement supérieure à celles des structures classiques à 4 et même à 3 doigts par longueur d'ondes. En particulier, pour les structures d'électrodes potentiellement affectées par des étapes de recuit ou souffrant de problèmes d'adhérence sur le substrat, l'augmentation de la surface des électrodes est avantageuse pour atteindre des fréquences potentiellement supérieures à 1 GHz sur quartz et sur langasite.

Résonateurs à modes multiples

Dans les configurations précédentes, un seul espace $g_1$ a été considéré pour optimiser la réponse électrique, cet espace étant généralement inférieur ou voisin de la longueur d'onde et optimisé pour améliorer la pureté spectrale de la réponse électrique du résonateur dans une configuration à mode unique. Il est toutefois pertinent de considérer un résonateur pour lequel les espaces $g_1$ et $g_2$ (cf. figure 6) sont un multiple (pas forcément multiple entier) de la longueur d'onde de sorte que plusieurs résonances puissent s'établir dans la bande de fonctionnement prévue. On constitue entre les deux miroirs de Bragg une cavité au sein de laquelle se situe le transducteur selon l'invention. Le transducteur émet et détecte les ondes de surface dans la bande interdite f4-f5 des miroirs mais pas dans sa bande interdite propre f2-f3. Le transducteur sert d'une part à pomper la cavité et d'autre part à l'interroger grâce aux effets piézoélectriques inverse et direct. Dans cette situation, la Figure 6 est toujours pertinente. L'espace est optimisé afin de permettre à au moins deux modes de la cavité d'être détectés de manière claire. La figure 19 illustre la réponse en réflexion ($S_{11}$) d'un résonateur multimode sur langasite avec plusieurs contributions dans la bande ISM, coupe (YX/$lt$)/48,5°/26,7° avec une structure d'espaces non symétrique ($g_1$=1987 $\mu$m, $g_2$=1988,3 $\mu$m), 150 électrodes dans les miroirs, métallisation en platine de 142 nm d'épaisseur, ouverture acoustique 300 $\mu$m.

Une telle configuration de capteur permet de placer plusieurs résonances dans la bande ISM comme le montre la figure 19 qui correspond à un résonateur avec au moins 3 résonances dans ladite bande (centrée en 433,9 MHz de largeur 1,7 MHz) et engendre de fait des fonctionnalités intéressantes. Dans ladite structure, on tire parti des propriétés particulières de la langasite (coupe (YX/$lt$)/48,5°/26,7°) et plus spécifiquement de la vitesse de phase des modes de Rayleigh sur ce substrat notablement inférieure à celle des mêmes ondes sur les substrats monocristallins « classiques » (quartz, niobate et tantalate de lithium) et qui par voie de conséquence permet de réduire la taille du dispositif. Pour une fréquence $f_r$ donnée, la longueur d'onde acoustique $\lambda_{ac}$ est proportionnelle à la vitesse de phase $V_\varphi$ telle que $V_\varphi = f_r \times \lambda_{ac}$. Est considéré ici un transducteur à 3 doigts par $\lambda_{ac}$ avec 100 longueurs d'ondes, un espace à gauche du transducteur de 1987 $\mu$m et un espace à droite de 1988,2 $\mu$m, cet écart entre les deux espaces étant optimisé pour éliminer les modes parasites entre les quatre modes principaux dont on voit une légère signature sur la figure 19. Les miroirs comptent 150 électrodes en platine Pt à la condition de Bragg (2 doigts par $\lambda_{ac}$) avec un rapport de métallisation (ici du platine) a/p fixé à 0,53 pour une épaisseur de 142 nm (épaisseur relative $h/\lambda_{ac}$ =2,38%). Cette épaisseur du dépôt de métal joue un rôle majeur dans la définition de la vitesse de phase du mode sous le réseau d'électrodes. L'ouverture acoustique est fixée à 300 $\mu$m. La période mécanique au sein du transducteur est de 1,987 $\mu$m et dans le miroir de 2,957 $\mu$m. Le premier espace $g_1$ représente donc une longueur $d_1$ de 333,333 longueurs d'onde acoustique et le second espace $g_2$ une longueur $d_2$ de 333,53 $\lambda_{ac}$. La fréquence f2 peut être égale à 657 MHz. La fréquence f2 peut être égale à 660,5 MHz. La fréquence f4 peut être égale à 438 MHz. La fréquence f5 peut être égale à 440 MHz. La fréquence f6 peut être égale à 439 MHz. La fréquence f7 peut être égale à 439 MHz.

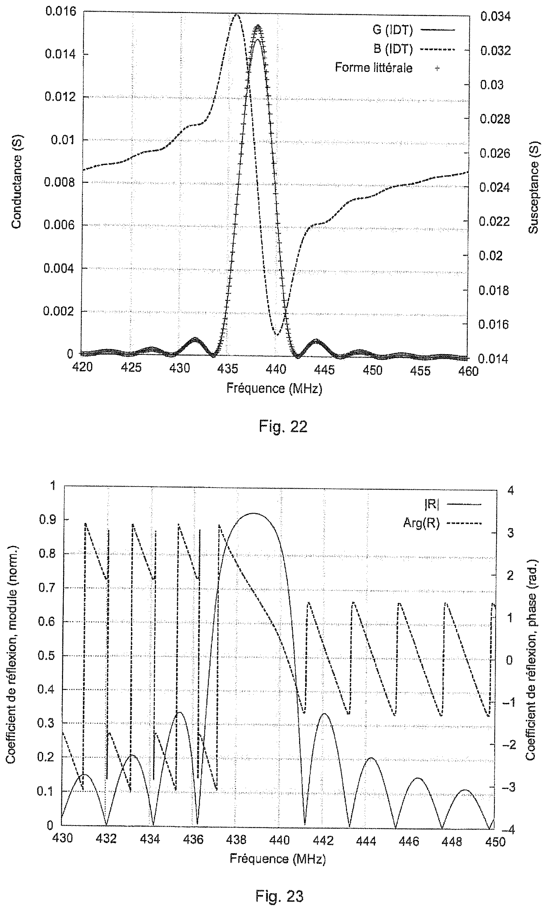

En comptant les 100 longueurs d'onde acoustique $\lambda_{ac}$ du transducteur additionnées à ces deux espaces, la cavité inter-miroir présente une longueur de 766,86 $\lambda_{ac}$, ce qui permet de calculer l'écart entre modes en considérant une vitesse de phase de l'onde de Rayleigh d'environ 2585 m.s$^{-1}$ pour l'orientation cristalline choisie et la nature des électrodes considérées ici (données calculées par analyse harmonique pour un réseau périodique infini, en supposant cette valeur constante dans le résonateur ce qui est correct en première approximation) et un miroir dont l'effet de réflexion total serait localisé de manière univoque en son point d'entrée (vue du transducteur). La demanderesse s'est aperçue qu'il faut également tenir compte de la longueur du miroir. En procédant de la sorte et en supposant effectivement que l'écart de fréquence entre deux modes est donné par $\Delta f = V_\varphi/2L_c$ ($L_c$ étant la longueur équivalente de la cavité), on obtient un écart de fréquence de l'ordre de 236 kHz, soit une valeur proche mais différente de celles déduites de la figure 22 pour laquelle les espaces sont pris égaux à 1987 μm, n'optimisant pas de fait la distribution spectrale de la réponse du résonateur. Cette courbe théorique montre que les écarts fréquentiels entre contributions alternent entre 190 et 260 kHz et évoluent selon les fréquences croissantes de sorte que cet écart se réduise régulièrement. Le calcul proposé plus haut ne peut donc servir qu'à une estimation de l'écart fréquentiel entre résonances mais permet néanmoins un premier dimensionnement du résonateur. Si l'on admet donc que l'écart entre deux modes $a$ et $b$ est donné par $f_b - f_a = V\varphi/2L_c$, alors on montre que cet écart évolue en fonction de la température comme suit :

$$\frac{\Box f}{f_0}(T) = \frac{f(T) - f_0}{f_0} = \frac{\Box V_{\Box}}{V_0}(T) - \frac{\Box L_c}{L_c(T_0)}(T) \qquad (1)$$

avec

$$\frac{\Box V_{\Box}}{V_0} = \frac{V_{\Box}(T) - V_0}{V_0} = CTV_1(T - T_0) + CTV_2(T - T_0)^2 + CTV_3(T - T_0)^3 \qquad (2)$$

et

$$L_c(T) = L_c(T_0) \times \left(1 + \Box_1^{(1)}(T - T_0) + \Box_1^{(2)}(T - T_0)^2 + \Box_1^{(3)}(T - T_0)^3\right) \qquad (3).$$

Dans ces équations, les paramètres $\alpha_1^{(i)}$ représentent les coefficients de dilatation du substrat (généralement positifs) et les $CTV_i$ les coefficients de température de la vitesse pour une description en développement selon les différentes puissances de $T$. $V_0$ représente la vitesse de phase des ondes élastiques de surface à la température de référence $T_0$. $V_\varphi(T)$ représente la vitesse de phase des ondes élastiques de surface à la température $T$. Par conséquent, en considérant une coupe pour laquelle la dérive thermique de la vitesse de phase est négative, l'écart entre les pics diminue selon la température de manière identique à la loi fréquence-température caractérisant le mode de surface. Si la variation absolue de cet écart de fréquence s'avère beaucoup plus faible que celle des fréquences de résonance elles-mêmes, et par voie de conséquence plus difficile à mesurer, la mesure de température déduite de cette grandeur présente l'avantage fondamental d'être naturellement différentielle sans nécessiter plusieurs résonateurs. En définitive, le recours à un seul transducteur excitant plusieurs modes de même nature dont l'écart spectral est la grandeur utile s'avère plus robuste que les autres méthodes mises en œuvre jusqu'à présent vis-à-vis des effets perturbateurs corrélés (effets de contrainte ou variations des propriétés de l'antenne par exemple). Enfin, si les coefficients du premier ordre l'emportent sur les termes d'ordre plus élevé en température, une loi de comportement linéaire sera hautement représentative, telle que :

$$f_1(T) - f_1(T_0) - (f_2(T) - f_2(T_0)) = (f_1(T_0) - f_2(T_0))(CTV_1 - \Box)(T - T_0) \qquad (4),$$

soit

$$\frac{\Box(\Box f)}{(\Box f)}(T) = (CTV_1 - \Box) \times (T - T_0) \qquad (5)$$

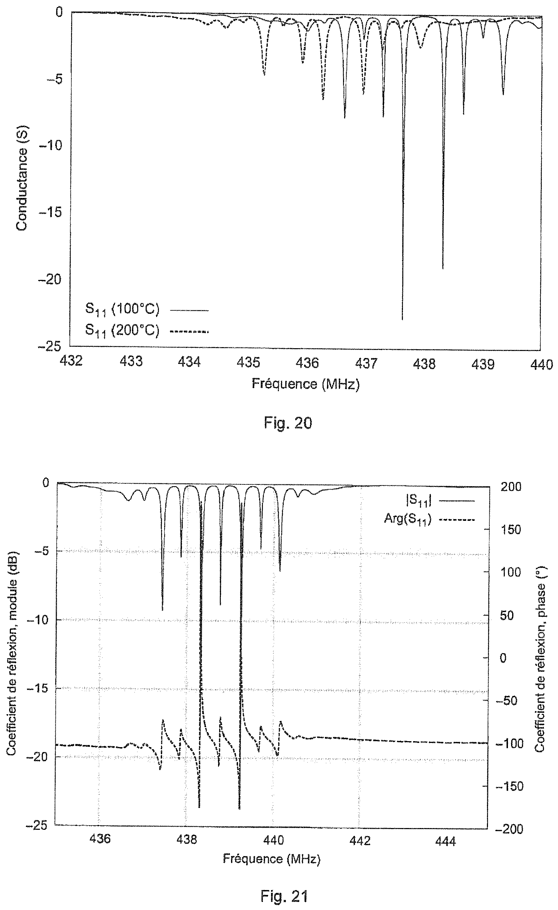

Dans le cas de la coupe de langasite utilisée ici comme illustration, la sensibilité thermique du mode calculée avec les constantes de Bungo et al [A. Bungo & al, Analysis of Surface Acoustic Wave Properties of the Rotated Y-cut Langasite Substrate, Japanese Journal of Applied Physics Volume 38 Part 1, Number 5B] s'avère de l'ordre de -12,6 ppm.K$^{-1}$ et -73,9 ppb.K$^{-2}$ (coefficients de température des premier et deuxième ordres) pour un coefficient de dilatation au premier ordre de 5 ppm.K$^{-1}$. Bien que modestes, ces valeurs permettent de mettre en évidence pour une configuration donnée la loi de variation effective de l'écart entre deux modes principaux de la structure. Soit par exemple une structure de résonateur rigoureusement conforme au type de la figure 6 avec deux modes principaux parfaitement dissociés présentant un écart spectral maximisé, obtenue sur la coupe de langasite retenue ici pour illustration et sans perte de généralité (les coordonnées géométriques de la structure étant fournies en Tableau 2). La structure de résonateur à cavité asymétrique est effectivement intéressante pour ce type de composants, permettant un degré de liberté supplémentaire en termes d'optimisation de la réponse spectrale. La variation de l'écart de fréquence par exemple entre 100 et 200°C de température de fonctionnement s'avère de l'ordre de 2 kHz, en ligne avec les résultats d'un calcul fondé sur l'équation (1) en considérant les valeurs de coefficients de sensibilité mentionnées ci-dessus annonçant une variation de fréquence de 2,175 kHz dans l'hypothèse d'une fréquence $f_0$ égale à 680 kHz (l'écart entre les deux modes à 25°C). La figure 20 montre le résultat de simulation de la réponse du résonateur à 100 et 200°C. La figure 20 montre l'évolution de la réponse d'un résonateur asymétrique selon le Tableau 2 à électrodes de Pt sur langasite (YX*lt*)/46.5°/26.7° à deux températures différentes, et caractérise la variation de l'écart entre les deux modes principaux par mise en évidence des pertes d'insertion induites par la chute des coefficients de transduction et de réflexion.

Ladite configuration de résonateur est suffisante pour illustrer l'intérêt de l'invention dans la mesure où les pertes d'insertion croissent assez vite pour cette coupe, les coefficients de réflexion (caractérisant les miroirs) et de conduction (représentatif des propriétés du transducteur) chutant rapidement avec la température. D'autres configurations peuvent être encore plus spectaculaires.

Pour exploiter au mieux l'effet, une configuration est choisie pour laquelle les coefficients de réflexion et de transduction du résonateur présentent une tenue en température optimale, par exemple une variation inférieure à 10% de leur valeur nominale (à 25°C) pour 100°C d'excursion. De même, on cherchera des orientations cristallines permettant des coefficients de réflexion des ondes suffisamment élevés pour un étalement spectral de la fonction de réflexion aussi large que possible.

Tableau 2: Caractéristiques géométriques de la structure considérée pour illustrer le mode de fonctionnement du résonateur multimode pour une mesure différentielle de température Ces éléments constitutifs du résonateur permettent de mieux comprendre le fonctionnement du résonateur.

| | |
|---|---|
| Matériau et orientation cristalline (IEEE Std-176) Ouverture acoustique | Langasite coupe (YX*lt*)/48.5°/26,7° 300 $\mu$m |
| Nature et épaisseur des électrodes | Platine (Pt), 118 nm |
| Structure et longueur du transducteur | 3 doigts/$\lambda_{ac}$ - 100 $\lambda_{ac}$ (300 électrodes) |
| Période du transducteur et rapport de métallisation | 1,989 $\mu$m - 0,5 |
| Structure et longueur des miroirs | 2 doigts/$\lambda_{ac}$ - 100 $\lambda_{ac}$ (200 électrodes) |
| Période du transducteur et rapport de métallisation | 2,973 $\mu$m - 0,5 |
| Longueur d$_1$ et d$_2$ des cavités g$_1$ et g$_2$ | 994,5 $\mu$m - 1990 $\mu$m |

En figure 22, est tracée la réponse en admittance du transducteur seul avec comparaison entre le calcul de matrice mixte et l'expression littérale de la conductance de rayonnement. En figure 21 est tracée la réponse en réflexion S$_{11}$ d'un résonateur multimode sur langasite avec plusieurs contributions dans la bande ISM, coupe (YX*lt*)/48,5°/26,7° avec une structure de cavités symétrique (g=987,6 $\mu$m), 200 électrodes dans les miroirs, métallisation en platine de 118 nm d'épaisseur, ouverture acoustique 300 $\mu$m. La réponse présente un aspect de fonction de la famille sinX/X, représentative des propriétés de la coupe même. La largeur de bande de la réponse est donnée par le nombre de longueurs d'onde du transducteur (soit sa longueur physique) et la vitesse de phase V$_R$ du mode de Rayleigh excité par le transducteur. La vitesse de phase du mode de Rayleigh excité par le transducteur divisée par la longueur d'onde du mode définit la fréquence centrale de la fonction sinX/X. Ces éléments permettent entre autres de déterminer la durée de la réponse impulsionnelle du transducteur.

En se fondant sur les relations élémentaires décrivant le fonctionnement du peigne inter-digité (E. Dieulesaint, D. Royer, «Propagation et génération des ondes élastiques », Techniques de l'Ingénieur e3210, 10/02/2001), la durée de l'impulsion $\Theta$ suite à une excitation de Dirac s'exprime telle que :

$$\Theta = N/f_0 \qquad\qquad (6)$$

avec $N$ le nombre de longueurs d'onde du transducteur et $f_0$ la fréquence d'excitation propre au peigne donnée par :

$$f_0 = V_R / \lambda_{ac} \qquad (7)$$

$\lambda_{ac}$ la longueur d'onde acoustique est égale à $3p$, $p$ la période du réseau d'électrodes, si le transducteur fonctionne par exemple avec une structure à 3 doigts par longueur d'onde. Donc on en déduit que

$$\Theta = N\lambda_{ac}/V_R \qquad (8)$$

Avec 100 $\lambda_{ac}$, avec $\lambda_{ac}=6$ μm environ et une vitesse de phase de l'ordre de 2615 m.s$^{-1}$, la durée d'un paquet d'onde excité par une sollicitation de Dirac est donc de 0,23 μs correspondant à une largeur de bande de l'ordre de 4,4 MHz (la largeur de bande de la réponse spectrale du transducteur à - 3 dB vaut à peu près 3,8 MHz).

La fonction de réflexion acoustique R($\omega$) du miroir est reportée en figure 23, couvrant pratiquement le lobe principal de la réponse du transducteur (figure 22). Les résonances principales s'inscrivent dans la bande 437-440 MHz correspondant en première approximation au recouvrement des réponses spectrales du transducteur et du miroir prises à mi-hauteur (partie réelle de l'admittance figure 22 et module du coefficient de réflexion figure 23). Les dimensionnements du miroir et du transducteur dépendent principalement des caractéristiques physiques du mode sur le matériau sélectionné.

La fonction de réflexion remplie par le miroir pour cette configuration suffit à créer les conditions de résonance nécessaires pour engendrer les modes multiples recherchés. Une telle configuration est améliorable en jouant sur les paramètres technologiques de fabrication du dispositif, notamment pour augmenter le coefficient de réflexion ici notablement inférieur à 1 et la largeur spectrale ne couvrant pas complètement, ici, le lobe principal du module de l'admittance du transducteur.

Le coefficient de réflexion d'un miroir de Bragg à électrodes multiples peut être calculé relativement simplement en considérant des champs scalaires incident et réfléchi sur un obstacle unique. Le formalisme dit de matrice mixte a pour vocation de relier les sorties acoustiques $S$ de chaque cellule élémentaire (pouvant se réduire à une seule période du réseau) à ses entrées acoustiques $E$ et décrit surtout les couplages électroacoustiques pour un mode donné de la structure. En l'absence d'effets de transduction, celle-ci s'écrit comme suit :

$$\begin{Bmatrix} S_1 \\ S_2 \end{Bmatrix} = \begin{bmatrix} r_{11} & t_{12} \\ t_{21} & r_{22} \end{bmatrix} \begin{Bmatrix} E_1 \\ E_2 \end{Bmatrix} = \begin{bmatrix} -j\sin(\Box)e^{-j(\Box_1 + \Box_r)} & \cos(\Box)e^{(-j\Box_1)} \\ \cos(\Box)e^{(-j\Box_2)} & -j\sin(\Box)e^{-j(\Box_2 - \Box_r)} \end{bmatrix} \begin{Bmatrix} E_1 \\ E_2 \end{Bmatrix} \qquad (9)$$

L'équation (9) fait apparaître les coefficients $r$ et $t$ décrivant les phénomènes de diffraction acoustique observés en bords de cellule ($r$ et $t$ désigne respectivement la réflexion et la transmission). A l'aide de relations fondamentales telles que la conservation de l'énergie [J.M. Hodé, J. Desbois, Original basic properties of the Green's functions of a semi-infinite piezoelectric substrate, IEEE Ultrasonics Symposium Proceedings, vol.1, no., pp.131,136, 1999], le nombre de paramètres indépendants de la matrice mixte peut être significativement réduit. Notons que $r_{11}$ et $r_{22}$ sont identiques si les centres de réflexion et de transduction de la cellule le sont également. On remarquera cependant la dissociation du coefficient de réflexion à gauche et à droite de la cellule compte tenu de l'existence possible de propriétés de directivité du substrat. Afin de respecter la conservation de l'énergie, les coefficients de la matrice mixte peuvent être explicités comme suit :

$$\begin{Bmatrix} S_1 \\ S_2 \end{Bmatrix} = \begin{bmatrix} -j\sin(\Box)e^{-j\Box} & \cos(\Box)e^{-j\Box} \\ \cos(\Box)e^{-j\Box} & -j\sin(\Box)e^{-j\Box} \end{bmatrix} \begin{Bmatrix} E_1 \\ E_2 \end{Bmatrix} \qquad (10)$$

L'explication de la simplification pratiquée en (10) vient selon Hodé et al (cf. réf. ci-dessus) du fait que l'on peut toujours choisir arbitrairement l'origine des phases de telle sorte que $\varphi_1$ $\varphi_2$. Une matrice de diffraction sans pertes doit être purement imaginaire, d'où $[S][S]^* = [I]$ qui impose également l'égalité $\varphi_1 = \varphi_2$. $\sin(\Delta)$ est le module du coefficient de réflexion élémentaire de l'onde sous l'électrode. La matrice de diffraction est transformée en matrice de transmission comme suit :

$$
\begin{Bmatrix} E_1 \\ S_1 \end{Bmatrix} = \begin{bmatrix} j\tan(\square) & \dfrac{e^{+j\square}}{\cos(\square)} \\ \dfrac{\cos(2\square)}{\cos(\square)}e^{-j\square} & -j\tan(\square) \end{bmatrix} \begin{Bmatrix} E_2 \\ S_2 \end{Bmatrix}
$$

(11)

pouvant être mise en cascade pour simuler la réflexion du miroir [D.P. Morgan, Surface wave devices for signal processing, Studies in Electrical Eng. 19, Elsevier Ed., 2nd Ed 2007]. La correspondance entre les termes d'entrée et de sortie d'une cellule (période) à l'autre est souhaitable lors de cette opération de cascade. Soit $E'$ et $S'$ les entrée et sortie de la cellule suivante, connectée côté 2 ; celles-ci vont correspondre respectivement aux sortie et entrée $S_2$ et $E_2$ de la première cellule (les entrée et sortie opposée sont notées respectivement $E_3$ et $S_3$). On modifie l'agencement de la nouvelle matrice de sorte que ladite matrice soit directement multipliée à la matrice (11) pour donner lieu à la nouvelle matrice des deux cellules ainsi associées. Il vient :

$$
\begin{Bmatrix} E_1 \\ S_1 \end{Bmatrix} = \begin{bmatrix} j\tan(\square) & \dfrac{e^{+j\square}}{\cos(\square)} \\ \dfrac{\cos(2\square)}{\cos(\square)}e^{-j\square} & -j\tan(\square) \end{bmatrix} \begin{bmatrix} \dfrac{\cos(2\square)}{\cos(\square)}e^{-j\square} & -j\tan(\square) \\ j\tan(\square) & \dfrac{e^{+j\square}}{\cos(\square)} \end{bmatrix} \begin{Bmatrix} E_3 \\ S_3 \end{Bmatrix}
$$

, (12)

soit :

$$
\begin{Bmatrix} E_1 \\ S_1 \end{Bmatrix} = \begin{bmatrix} \dfrac{j\tan(\square)(\cos(2\square)e^{-j\square}+e^{+j\square})}{\cos(\square)} & \tan^2(\square)\dfrac{e^{+j2\square}}{\cos^2(\square)} \\ \dfrac{\cos^2(2\square)}{\cos^2(\square)}e^{-j2\square}+\tan^2(\square) & \dfrac{-j\tan(\square)(\cos(2\square)e^{-j\square}+e^{+j\square})}{\cos(\square)} \end{bmatrix} \begin{Bmatrix} E_3 \\ S_3 \end{Bmatrix}
$$

(13)

Sachant que l'on doit toujours vérifier que la somme du module de réflexion au carré et du module de transmission au carré égale 1, cos(Δ) se déduit de sin(Δ) une fois actualisé. On peut donc calculer l'évolution du pouvoir de réflexion du miroir en cascadant N matrices (13) pour un nombre égal d'obstacles élémentaires et reconstruire une matrice de diffraction une fois le calcul effectué par retour à la matrice S initiale comme suit :

$$
\begin{Bmatrix} E_1 \\ S_1 \end{Bmatrix} = \begin{bmatrix} C_{11} & C_{1N} \\ C_{N1} & C_{NN} \end{bmatrix} \begin{Bmatrix} E_N \\ S_N \end{Bmatrix} \rightarrow \begin{Bmatrix} E_1 \\ S_1 \end{Bmatrix} = \frac{1}{C_{1N}} \begin{bmatrix} C_{NN} & C_{1N}C_{N1}-C_{11}C_{NN} \\ 1 & -C_{11} \end{bmatrix} \begin{Bmatrix} E_N \\ S_N \end{Bmatrix}
$$

(14)

où se retrouve bien la définition d'un coefficient de réflexion global au travers de $1/C_{1N}$.

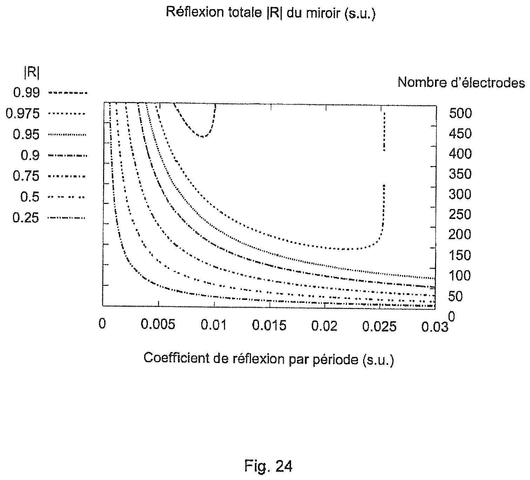

La figure 24 est une cartographie de la fonction de réflexion d'un miroir à électrodes distribuées périodiquement selon le nombre d'électrodes et l'intensité du coefficient de réflexion unitaire. L'existence d'un optimum pour $|R|_{unit}$=1% au-delà de 400 électrodes est mis en évidence.

Le tracé de la figure 24 est universel et peut donc s'appliquer à n'importe quel phénomène physique linéaire pouvant être décrit par les équations (9) à (14). En particulier, le coefficient de réflexion conditionne d'une part la largeur de bande de la fonction de réflexion et d'autre part le module de la fonction de réflexion remplie par le miroir dans sa globalité. Dès une valeur de réflexion unitaire supérieure à 1,5%, il suffit de 150 électrodes pour dépasser un pouvoir réflecteur de 0,975. Par contre, le calcul montre qu'il est avantageux de recourir à un coefficient de réflexion de 0,5 à 1% dès qu'il est possible de combiner plus de 300 électrodes. Il est alors possible d'atteindre un coefficient de réflexion de 0,99. Malgré l'apparente simplicité du calcul et son caractère linéaire, la Demanderesse a mis en évidence cet optimum, a priori non expliqué. La largeur de bande de la fonction de réflexion est par ailleurs proportionnelle au coefficient de réflexion unitaire via la formule :

$$R = \sin(\Delta)(T) = \pi \frac{f_s - f_e}{f_s + f_e} \qquad (15)$$

avec $f_s$ et $f_e$ les fréquences de sortie et d'entrée de bande d'arrêt correspondant à la zone spectrale de Bragg. Connaissant la valeur du coefficient de réflexion et la fréquence centrale d'un dispositif donné, la Demanderesse en déduit l'étalement de la fonction de réflexion réalisée par le miroir correspondant. Ainsi, il est pertinent de faire se recouvrir spectralement les fonctions de transduction et de réflexion pour optimiser le fonctionnement du transducteur. L'invention ne se limite pas aux exemples de dispositif capteur à ondes élastiques de surface interrogeable à distance décrits ci-avant, seulement à titre d'exemple, mais elle englobe toutes les variantes que pourra envisager l'homme de l'art dans le cadre des revendications ci-après.

**Revendications**

1. Dispositif de capteur à ondes élastiques de surface interrogeable à distance comprenant un transducteur à peignes inter-digités et deux miroirs de Bragg disposés d'un côté et de l'autre du transducteur, l'ensemble formant un résonateur simple-port, le transducteur présentant une fréquence de synchronisme f1 et une bande interdite entre les fréquences f2 et f3 et les miroirs de Bragg présentant une bande interdite entre les fréquences f4 et f5, la fréquence f1 étant comprise dans la bande interdite f4-f5 des miroirs de Bragg, la bande interdite f2-f3 du transducteur étant située hors de la bande interdite f4-f5 des miroirs de Bragg.

2. Dispositif selon la revendication 1, dans lequel les miroirs de Bragg sont disposés à des distances d1 et d2 du transducteur comprises entre 10 et 1000 fois la longueur d'onde V1/f1 de façon que la propagation de l'onde élastique soit multimode entre chaque miroir de Bragg et le transducteur.

3. Dispositif selon l'une des revendications précédentes, dans lequel le résonateur présente une dérive thermique négative de la vitesse de phase, de façon que l'écart fréquentiel entre les modes diminue selon la température de manière identique à la loi fréquence-température caractérisant le mode de surface, la mesure de température déduite dudit écart étant naturellement différentielle.

4. Dispositif selon l'une des revendications précédentes, dans lequel le transducteur comprend des doigts parallèles de période comprise entre 1/3 et 1/2 de la longueur d'onde $\lambda$ = V1/f1, une période étant la somme d'une largeur digitale et d'une largeur interdigitale.

5. Dispositif selon la revendication 4, dans lequel le transducteur comprend sept doigts de période sensiblement égale à 3 fois la longueur d'onde $\lambda$ = V1/f1, préférentiellement en configuration +V/-V/+V/+V/-V/+V/-V.

6. Dispositif selon la revendication 4, dans lequel le transducteur comprend cinq doigts de période sensiblement égale à 2 fois la longueur d'onde $\lambda$ = V1/f1, préférentiellement en configuration +V/+V/-V/-V/+V ou +V/-V/-V/+V/-V.

7. Dispositif selon la revendication 4, dans lequel le transducteur comprend huit doigts de période sensiblement égale à 3 fois la longueur d'onde $\lambda$ = V1/f1, préférentiellement en configuration 0/-V/+V/-V/0/+V/-V/+V, 0 étant un potentiel flottant.

8. Dispositif selon l'une des revendications précédentes, dans lequel, les miroirs de Bragg présentant au sein de la bande interdite f4-f5 un maximum de réflexion à une fréquence f6, et le résonateur présentant un maximum d'excitation à une fréquence f7, f6 = f7 à 10% de la largeur $\delta f$ de la bande interdite des miroirs de Bragg près, avec $\delta f$ = (f4-f5).

9. Dispositif selon l'une des revendications précédentes, dans lequel le résonateur comprend un substrat piézoélectrique comprenant au moins un matériau choisi parmi: langasite, quartz, $LiTaO_3$, $LiNbO_3$, $GaPO_4$, $LiBa_4O_7$, $KNbO_3$, un film mince comprenant une couche d'AlN, d'AlScN ou de ZnO sur un substrat à base de Si, saphir, grenat (YAG, YIG), carbure de silicium, diamant synthétique, verre et ses composés dérivés, ou quartz.

10. Dispositif selon la revendication 9, dans lequel le substrat piézoélectrique est un substrat Langasite avec une coupe (YX*lt*)/48.5°/ 26. 7°.

**11.** Dispositif selon l'une des revendications précédentes, dans lequel le résonateur comprend des électrodes déposées à la surface d'un substrat piézoélectrique, les électrodes comprenant au moins un matériau choisi parmi: Al, Ti, Pt, Ta, Au, W, Ir, Ni, Cr, Mo, Zr, Pd, Ag, Cu, alliage comprenant plus de 90% d'Al et au moins un parmi: Cu, Si et Ti.

**12.** Dispositif selon l'une des revendications précédentes, dans lequel chaque miroir de Bragg comprend un nombre de couches compris entre 50 et 1000.

**13.** Dispositif selon l'une des revendications précédentes, dans lequel chaque miroir de Bragg comprend un nombre de couches proportionnel au coefficient de réflexion de l'onde élastique sur une couche unique.

**14.** Dispositif selon l'une des revendications précédentes, dans lequel les miroirs de Bragg sont disposés symétriquement par rapport au transducteur.

**15.** Dispositif selon l'une des revendications précédentes, comprenant au moins une parmi les propriétés suivantes:

- un nombre N d'électrodes du transducteur en fonction du coefficient de couplage ks<2> et de la permittivité piézoélectrique équivalent $\varepsilon$ du substrat, avec N = G/($\omega$.ks<2> .4.$\varepsilon$.VV) avec G la conductance de rayonnement égale en première approximation à l'inverse de la résistance motionelle du circuit équivalent de Butterworth - V anDyke, $\omega$ la pulsation et W l'ouverture acoustique (la longueur de recouvrement de deux électrodes de polarité opposée au sein du transducteur);
- une somme de largeur d'électrodes du transducteur et de largeur inter-électrodes de résonateur comprise entre 2000 et 6000 m.s<-1> (soit la vitesse de phase du mode) divisé par pe /pm fois la fréquence nominale de travail, avec pe la période de répétition du motif d'excitation électrique et pm la période de répétition de la structure mécanique des électrodes ;
- un rapport de largeur d'électrodes du transducteur sur largeur inter-électrodes du transducteur compris entre 0,3 et 0,7 ;
- un rapport épaisseur d'électrodes du transducteur sur longueur d'onde élastique $\lambda$ = V1/f1 compris entre 2,30 et 2,40% ;
- un nombre d'électrodes de miroir de Bragg donné par la fonction N(|R|)= Partie entière (A/(B×|R| +C)) avec |R| l'efficacité de réflexion de chaque électrode, A = 1520, B=660 et C= 2,5×10<-2> pour que le coefficient de réflexion global du miroir dépasse 0,97, [R] étant compris entre 2,0×10<-3> et 2,5×10<-2> ;
- une période de miroir de Bragg pBragg comprise entre V1/(2×f4) et V1/(2×f5) avec f4-f5 la largeur de la bande interdite et la fréquence nominale de travail étant comprise dans cet intervalle ;
- un rapport épaisseur d'électrodes de miroir de Bragg sur largeur inter-électrodes de miroir de Bragg compris entre 0,5 et 0,7 ;
- un rapport épaisseur d'électrodes de miroir de Bragg sur longueur d'onde élastique $\lambda$ = V1/f1 compris entre 2,35 et 2,45% ;
- une distance entre miroir de Bragg et du transducteur comprise entre 1,00 et 2,00 $\mu$m ;
- une ouverture acoustique comprise entre 200 et 400 $\mu$m ;
- une épaisseur d'électrodes comprise entre 100 et 200 nm.

**16.** Dispositif selon l'une des revendications précédentes, comprenant au moins une parmi les propriétés suivantes:

- un nombre d'électrodes du transducteur compris entre 800 et 1000 ;
- une somme de largeur d'électrodes du transducteur et de largeur inter-électrodes du transducteur comprise entre 1,960 et 1,980 $\mu$m ;
- un rapport de largeur d'électrodes du transducteur sur largeur inter-électrodes du transducteur compris entre 0,3 et 0,7 ;
- un rapport épaisseur d'électrodes du transducteur sur longueur d'onde élastique $\lambda$ = V1/f1 compris entre 2,30 et 2,40% ;
- un nombre d'électrodes de miroir de Bragg compris entre 100 et 200 ;
- une somme de largeur d'électrodes de miroir de Bragg et de largeur inter-électrodes de miroir de Bragg compris entre 2,90 et 2,95 ;
- un rapport épaisseur d'électrodes de miroir de Bragg sur largeur inter-électrodes de miroir de Bragg compris entre 0,5 et 0,7 ;
- un rapport épaisseur d'électrodes de miroir de Bragg sur longueur d'onde élastique $\lambda$ = V1/f1 compris entre 2,35 et 2,45% ;
- une distance entre miroir de Bragg et résonateur comprise entre 1,00 et 2,00 $\mu$m ;

- une ouverture acoustique comprise entre 200 et 400 $\mu$m ;
- une épaisseur d'électrodes comprise entre 100 et 200 nm.

17. Dispositif selon l'une des revendications précédentes, comprenant un résonateur présentant une dérive thermique négative de la vitesse de phase, de façon que l'écart entre les pics diminue selon la température de manière identique à la loi fréquence-température caractérisant le mode de surface, la mesure de température déduite dudit écart étant naturellement différentielle.

18. Dispositif selon l'une des revendications précédentes, dans lequel le résonateur et les miroirs de Bragg présentent un recouvrement spectral, le coefficient de réflexion unitaire des miroirs de Bragg étant supérieur à 1,5% avec 150 électrodes ou plus pour atteindre un pouvoir réflecteur de 0,975 ou plus, et le coefficient de réflexion unitaire des miroirs de Bragg étant compris entre 0,5 et 1% avec 300 électrodes ou plus pour atteindre un pouvoir réflecteur de 0,99 ou plus.

Fig.1

Fig. 2a

Fig. 2b

Fig. 3a

Fig. 3b

Fig. 4

Fig. 5

Miroir M1
2d/

Transducteur 3d/

Miroir M2
2d/

Fig. 6

Fig. 7

Fig. 8a

Fig. 8b

Fig. 9a

Fig. 9b

Fig. 10a

Fig. 10b

Fig. 11a

Fig. 11b

Fig. 11c

Fig. 12

Fig. 13a

Fig. 13b

Fig.14

$$3 \times \lambda = 7 \times p$$

Fig. 15

Fig. 16

$$3 \times \lambda = 8 \times p$$

Fig. 17

Fig. 18

Fig. 19

Fig. 20

Fig. 21

Fig. 22

Fig. 23

Fig. 24

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2906630

**Littérature non-brevet citée dans la description**

- **HICCUP, VOIR P.V. WRIGHT.** A review of SAW resonator filter technology. *Proc. of the IEEE Ultrasonics Symposium,* 1992, vol. 1, 29-38
- **S. BALLANDRAS ; A. REINHARDT ; V. LAUDE ; A. SOUFYANE ; S. CAMOU ; W. DANIAU ; T. PASTUREAUD ; W. STEICHEN ; R. LARDAT ; M. SOLAL.** Simulations of surface acoustic wave devices built on stratified media using a mixed finite element/boundary element intégral formulation. *Journal of Applied Physics,* 2004, vol. 96 (12), 7731-7741
- **A. BUNGO.** Analysis of Surface Acoustic Wave Properties of the Rotated Y-cut Langasite Substrate. *Japanese Journal of Applied Physics,* vol. 38 (5B
- **E. DIEULESAINT ; D. ROYER.** Propagation et génération des ondes élastiques. *Techniques de l'Ingénieur,* 10 Février 2001, e3210
- **J.M. HODÉ ; J. DESBOIS.** Original basic properties of the Green's functions of a semi-infinite piezoelectric substrate. *IEEE Ultrasonics Symposium Proceedings,* 1999, vol. 1, 131, , 136
- Surface wave devices for signal processing. **D.P. MORGAN.** Studies in Electrical Eng. Elsevier, 2007, vol. 19